# EUROPEAN PATENT APPLICATION

(11) **EP 1 445 805 A1**
(43) Date of publication of application: **11.08.2004**
(21) Application number: 03354011.3
(22) Date of filing: 07.02.2003
(51) Int. Cl.: H01L 39/24

(54) **Manufacture of high critical temperature superconducting part**

(71) Applicant: CENTRE NATIONAL DE LA RECHERCHE SCIENTIFIQUE (CNRS), 75794 Paris Cedex 16 (FR); The University of Cincinnati, Cincinnati, Ohio 45202 (US)
(72) Inventor: Tournier, Robert, 38850 Bilieu (FR); Chaud, Xavier, 38600 Fontaine (FR); Isfort, Dirk, 50937 Köln (DE); Shi, Donglu, Loveland, Ohio 45140 (US)
(74) Representative: de Beaumont, Michel

(57) **Abstract**

A manufacturing method of a single domain of a rare earth based high critical temperature superconducting oxide, to be used as a superconductor, having different electromagnetic properties in a privileged plane (ab) and in a privileged direction (c), comprising the steps of manufacturing an intermediate part (20) from grains or precursors of the rare earth oxide, said part comprising openings (22), said openings defining in the intermediate part material portions having, in the privileged plane, a thickness smaller than a predetermined thickness; manufacturing the single domain of the rare earth oxide from the intermediate part; and oxygenating the single domain to increase the oxygen rate of the rare earth oxide.

## Description

The present invention relates to a manufacturing method of a part made of a high critical temperature superconducting material.

More specifically, the present invention relates to a manufacturing method of a rare earth based high critical temperature superconducting oxide single domain part, for example a REBCO single domain. It will be understood that REBCO single domain means an imperfect single crystal domain of REBa₂Cu₃Oₓ, where RE stands for Rare Earth and x is characteristic of the oxygen rate. The single crystal is said to be imperfect since it may contain defects such as inclusions of other phases, pores, growth defects, etc. The rare earth can be yttrium (Y). YBa₂Cu₃Oₓ single domain will be called hereafter YBCO single domain.

REBCO single domains usually act like superconductors with high performances in critical current density, especially for high magnetic fields. Therefore, they are used to manufacture current limiters, magnetic bearings, motors or permanent magnets.

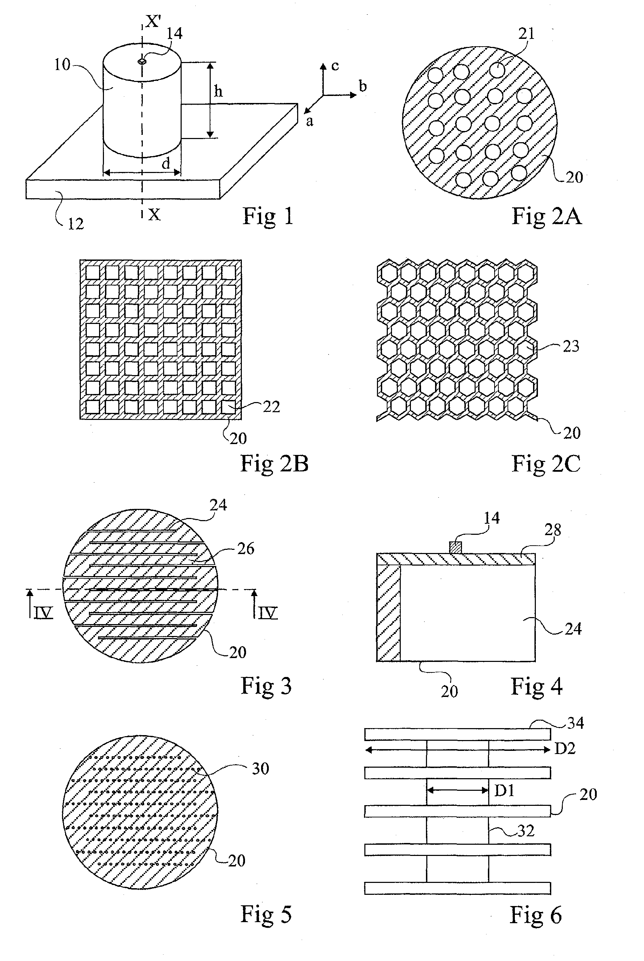

Figure 1 schematically shows a conventional intermediate part used to manufacture an YBCO single domain, for example, by way of a Top-Seeding-Melt-Texturing method. The part includes a cylindrical pellet 10 with height h and diameter d, obtained for example by sintering grains of a YBa₂Cu₃Oₓ phase, called hereafter Y123 phase, and grains of a Y₂Ba₂Cu₃O₅ phase, called hereafter Y211 phase. The pellet 10 is located on a base 12 made of a material which does not disturb the manufacture of the YBCO single domain. The base is, for example, a sintered alumina plate covered by an yttrium oxide layer Y₂O₃, a Y211 phase layer, a mixture of the Y123 phase and of a Yb123 phase (a phase of the same composition than the Y123 phase with ytterbium Yb instead of yttrium), etc.

The crystal structure of Y123 phase is strongly anisotropic. The elementary lattice consists in a stack extending in a preferential direction, called c direction, of perovskite type layers in specific planes, called ab planes. An YBCO single domain is obtained by texturing the sintered pellet 10. Therefore, a single crystal seed 14 of SmBa₂Cu₃Oₓ is located on the face of the pellet 10 opposed to the base 12. The compound SmBa₂Cu₃Oₓ belongs to the same perovskite group as the Y123 phase with an identical crystal structure wherein a samarium atom is substituted for the yttrium atom. The seed can also correspond to a SmBa₂Cu₃Oₓ single domain or MgO crystal. The seed surface in contact with the pellet 10 is orientated in an ab plane to cause the growth of the YBCO single domain.

The Y123 phase melting point (peritectic point) is about 1015°C. The seed melting point is about 50°C higher than the Y123 phase melting point. The pellet 10 can be heated above the melting point to obtain a complete melting of the Y123 phase grains without damaging the seed 14. The Y211 phase remains solid at such temperatures, whereby the pellet 10 keeps a substantially cylindrical shape. After completely melting the Y123 phase, the pellet 10 is cooled to the melting point, and then cooled very slowly, about from 0.1 to 0.5 degree per hour, so that only one Y123 phase grain may grow. A cylindrical YBCO single domain is thus obtained, made of an imperfect Y123 phase single crystal wherein Y211 phase particles are scattered.

With such a method, an YBCO single domain is achieved in which the Y123 phase oxygen rate x usually varies from 6.1 to 6.2. However, some properties of an YBCO single domain, including the resistivity in normal state, the critical temperature and the critical current, vary according to the oxygen rate x. For current applications, the oxygen rate to achieve is usually superior to 6.9. An oxygenation step of the single domain obtained by the above-described method must then be provided to obtain a material with an oxygen rate which corresponds to properties adapted to the wanted application. The oxygenation at a rate superior to 6.9 can be commonly achieved by annealing the single domain under flowing oxygen at about 420°C for several hours.

The oxygenated single domains obtained by common oxygenation methods have usually several drawbacks, especially cracks which spread mainly in ab planes. Cracks can appear during the first steps of the manufacture of the single domain, including during the manufacture of the pellet, the manufacture of the single domain and the cooling of the obtained single domain. However, most cracks seem to appear during the oxygenation step. The process which leads to the occurrence of the cracks during the oxygenation step also leads to the spreading of all the cracks which have already appeared during the first steps of the manufacture of the single domain. Such cracks spoil the superconductivity properties and the mechanical resistance properties of the single domain. Moreover, during the manufacture of the single domain from the pellet 10, voids or pores appear within the single domain because of the spreading of gaseous bubbles. The pores or voids tend also to spoil the mechanical resistance properties of the single domain.

An oxygenation method reducing the spreading of cracks is described in the article entitled "C-axis YBCO domains for current limiting applications" (SPA 2002) of R.F. Tournier, D. Isfort, D. Bourgault, X. Chaud, D. Buzon, E. Floch, L. Porcar, P. Tixador. However, such a method proves to be efficient for single domains which do not have a thickness higher than about 4 millimeters in the ab planes. It is then adapted to the oxygenation of single domains in the shape of rods extending in the c direction and does not allow the oxygenation of YBCO single domains with large dimensions in the ab plane.

However, for many applications, the manufacture of large size single domains is desirable both in the ab planes and in the c direction. For example, it can be desirable to manufacture current limiters wherein the current flows in the c direction. A possibility is then to mount several single domains in series and/or in parallel, for example in the shape of rods and plates, to obtain large dimensions current limiters. This can hardly be carried out at an industrial scale. Another possibility is, before the oxygenation step, to cut in a bulk YBCO single domain one or several parts with a narrow section in the ab plane, for example, a comb-shaped or H-shaped section. The spreading of cracks during the oxygenation step is then limited. However, such cutting steps are hard to perform and tend to initiate the spreading of new cracks.

Consequently, the purpose of this invention is to provide the manufacture of a REBCO superconductive part with large dimensions having a reduced number of cracks in the ab planes.

Another purpose of this invention is to provide the manufacture of a REBCO superconductive part with large dimensions having a reduced number of voids or pores.

To attain these purposes and others, the present invention provides a manufacturing method of a single domain of a rare earth based high critical temperature superconducting oxide, to be used as a superconductor, having different electromagnetic properties in a privileged plane and in a privileged direction, comprising the steps of manufacturing an intermediate part from grains or precursors of the rare earth based high critical temperature superconducting oxide, said part comprising openings, said openings defining in the intermediate part material portions having, in the privileged plane, a thickness smaller than a predetermined thickness; manufacturing the single domain of the rare earth based high critical temperature superconducting oxide from the intermediate part; and oxygenating the single domain to increase the oxygen rate of the rare earth based high critical temperature superconducting oxide.

According to an embodiment of the invention, the predetermined thickness is 4 millimeters.

According to an embodiment of the invention, the intermediate part is made by sintering grains of the rare earth based high critical temperature superconducting oxide, the manufacture of the openings being simultaneous to the manufacture of the intermediate part.

According to an embodiment of the invention, the intermediate part and the openings are obtained from extrusion of a paste comprising grains or precursors of the rare earth based high critical temperature superconducting oxide.

According to an embodiment of the invention, the openings are made by machining the intermediate part.

According to an embodiment of the invention, the manufacturing step of the rare earth based high critical temperature superconducting oxide includes a texturing step of the intermediate part by germination from a seed, an opening-free rare earth based high critical temperature superconducting oxide interface part being located between the seed and the intermediate part so that the recrystallization progresses from the seed successively into the interface part, and into the intermediate part.

The present invention provides an intermediate part comprising grains and/or precursors of a rare earth based high critical temperature superconducting oxide to be changed into a single domain of the rare earth based high critical temperature superconducting oxide used as a superconductor with different electromagnetic properties in a privileged plane and in a privileged direction, comprising openings defining in the intermediate part material portions having, in the privileged plane, a thickness smaller than a predetermined thickness.

According to an embodiment of the invention, the openings are cylindrical openings extending through the intermediate part along a direction intersecting the privileged plane.

According to an embodiment of the invention, the openings are polygonal cross-section openings extending through the intermediate part along a direction intersecting the privileged plane.

According to an embodiment of the invention, the openings are slots extending through the intermediate part parallel to the privileged direction.

According to an embodiment of the invention, the intermediate part includes parallel and spaced apart plates located on a trunk, each plate comprising openings.

The foregoing and others purposes, features and advantages of the invention will become apparent from the following detailed description of embodiments, given by way of illustration and not limitation with reference to the accompanying drawings:
figure 1, already described, schematically shows a conventional intermediate part to manufacture an YBCO single domain;
figures 2A to 2C show examples of pellet cross-sections according to the present invention used to manufacture an YBCO single domain;
figure 3 shows another example of a pellet cross-section according to the present invention;
figure 4 shows a section view of the pellet of figure 3 along the line IV-IV;
figure 5 shows another example of a pellet cross-section according to the present invention; and
figure 6 shows a side view of another example of a pellet according to the present invention.

The present invention will be described with reference to the manufacture of YBCO single domains from preshaped pellets containing at least one of the following phases: Y123, Y211 and/or Y₂O₃ phases. The invention consists in providing an adapted form of the preshaped pellet in order to reduce the spreading of cracks during the oxygenation step of the single domain obtained from the pellet.

According to the invention, openings or slots are provided in the pellet. The openings or slots penetrate into the pellet or go through the pellet in order to divide it in pellet portions, the thickness of the pellet portions in the ab planes being inferior to a critical thickness. The critical thickness is substantially of 4 millimeters. Beyond such a critical thickness, cracks tend to spread in the ab planes during the oxygenation step.

According to a first embodiment of the invention, the preshaped pellet is manufactured by sintering a powder containing Y123 and Y211 phases. Usually, additives must be added to prevent the Y211 phase from growing excessively in the liquid obtained after the melting of the Y123 phase. The catalysers may be platinum oxide or cerium oxide. An example of compound contains 70% per weight of the Y123 phase, 30% per weight of the Y211 phase and 0.15% per weight of platinum oxide in excess. The mixed powder is compacted under a pressure varying for example from 60 megapascal to 100 megapascal to form the pellet. Sintering is achieved for example by maintaining the part at 980°C for 12 hours.

The pellet shape can be defined by machining the sintered pellet or directly when the powder is compacted using a suitable mould.

From the preshaped pellet, the YBCO manufacturing method can be identical to the already described manufacturing method. It may consist to place a SmBa₂Cu₃Oₓ seed on one face of the pellet 20, the surface of the seed being orientated in an ab plane in order to cause the growth of an YBCO single domain. The preshaped pellet is heated beyond the Y123 phase melting point to completely melt the Y123 grains phase without damaging the seed. The Y211 phase remains solid at such temperatures so that the pellet keeps a cylindrical shape. After completely melting the Y123 phase, the pellet 10 is cooled in order to grow a single Y123 phase grain. According to an alternative embodiment, the preshaped pellet is made of a powder containing only the Y123 phase. Indeed, beyond the melting point, the Y123 phase changes into a liquid rich in copper and barium, and into a solid Y211 phase. The only Y211 phase obtained by this way is usually sufficient to maintain the cohesion in the pellet.

According to an alternative of the first embodiment, the seed is placed on the pellet during the manufacture of the single domain after overheating the pellet at a temperature at which the seed does not melt and before the slow cooling to grow the single domain. Then, the single domain growth goes on as previously described. An advantage of this alternative is that the overheating temperature is not limited anymore by the melting point of the seed.

According to a second embodiment of the present invention, the preshaped pellet does not contain the Y123 phase. The preshaped pellet includes, for example, only the Y211 or the Y₂O₃ phases. The manufacturing method of the YBCO single domain comprises the steps of locating a seed on the pellet, for example made of SmBa₂Cu₃Oₓ, or of NdBa₂Cu₃Oₓ where Nd corresponds to neodymium. The pellet is then heated at high temperature (for example 1050°C) in presence of liquid phase sources, for example solid barium or copper elements located at the preshaped pellet. The high temperature is such that the seed remains solid and the liquid phase sources melt. The obtained liquid phase infiltrates in the pellet by capillarity. A slow cooling is then carried out in presence of the seed so that the liquid phase partially reacts with the pellet in order to form the Y123 phase. The Y123 phase recrystallization in a single domain is driven by the seed as in the first embodiment. The obtained single domain is then a composite material with a Y123 matrix and Y211 inclusions. An advantage of the second embodiment is that the shape of the pellet remains substantially the same when forming the single domain. Moreover, the distribution of the Y211 phase in the obtained single domain is rather homogeneous. Besides, since the preshaped pellet does not contain the Y123 phase, this phase is not polluted by the manufacturing method of the pellet. The Y211 and Y₂O₃ phases being more stable than the Y123 phase, a rather aggressive manufacturing method can be used for the manufacture of the single domain even if the method could have led to the pollution of the Y123 phase, if present. For example, an extrusion method can be used with a paste comprising the Y211 or the Y₂O₃ phases and a binding material.

The following oxygenation step can be achieved as described in the already mentioned article. Advantageously, an oxygen overpressure can be provided in order to reduce the oxygenation step duration.

From multiple experiments, the applicant showed that the presence of the openings does not disturb the advancement of the Y123 phase single crystal growth front from the seed. Everything happens as if the Y123 phase single crystal growth front passed around the openings. Such a result is surprising since the single crystal growth is otherwise extremely sensitive to structural defects in the pellet. Moreover, the applicant has shown that the formation of the single domain does not substantially change the shape of the openings made in the pellet. The openings are thus maintained in the single domain.

Figure 2A shows an example of a pellet section in an ab plane according to the invention. The sintered pellet 20 has a cylindrical envelope, the height of which can reach some centimeters, and the diameter of which can reach about ten centimeters. The cylindrical openings 21 extend through the pellet 20 along the c direction. By way of example, the average diameter of the cylindrical openings 21 is about 0.8 millimeters and the average distance between the axles of two adjacent openings is less than 3 millimeters. According to an alternative of this first example, the openings 21 can be tilted with regard to the c direction.

Figure 2B shows another example of a pellet cross-section in an ab plane according to the invention. In this example, the pellet 20 has an usual square or rectangular outer shape. Openings 22 with a square cross-section are equally distributed and extend through the pellet along the c direction.

Figure 2C shows another example of a pellet section in an ab plane according to the invention. In this example, the pellet 20 has a honeycomb shape. Openings 22 with a hexagonal section are equally distributed and extend through the pellet along the c direction.

Figure 3 shows another example of a pellet section in the ab plane. Slots 24 extend through the pellet 20 on its entire height substantially along planes parallel to each other and perpendicular to the ab planes. The slots 24 define in the pellet 20 regions 26 in the shape of plane plates linked on their side edges. The average thickness of each region 26 in an ab plane is less than 4 millimeters. When the single domain is to be used as a current limiter, it can be desirable that a region 26 in sandwich between two other regions 26 is linked to a first side region along an edge and to the second side region along the opposite edge. Such a meander shape is particularly advantageous since the final single domain has directly a shape adapted to a use as a current limiter, thus reducing the finishing steps.

Figure 4 shows a section view of figure 3 along the line IV-IV. In order to improve the formation of the Y123 phase single crystal from the seed 14, a cylindrical plate 28, with the same composition than the pellet 20, can be located between the seed 14 and the pellet 20. The single domain growth front then advances firstly from the seed 14 into the plate 28, then from the plate 28 into the pellet 20.

Figure 5 shows another example of pellet section in an ab plane wherein each slot 24 is replaced by an alignment of cylindrical openings through the pellet 20 along the c direction. The cylindrical openings of a same alignment 30 have, for example, a diameter of 1 millimeter and a pitch of 2 millimeters. The applicant has shown, through multiple experiments, that cylindrical openings are substantially not damaged when the YBCO single domain grows. In the section example of figure 4, the slots 24, in some cases, may close partially or distort during the formation of the single domain. On the contrary, cylindrical openings remain substantially unchanged and, particularly, remain correctly aligned. The single domain may be sliced along the cylindrical openings 30 in order to obtain a section similar to the section of figure 3.

Figure 6 shows another example of sintered pellet 20 which comprises a cylindrical trunk 32 of diameter D1 on which coaxial cylindrical portions 34 of diameter D2 are regularly spaced. Openings, not shown, are provided through the cylindrical portions, for example, according to cylindrical openings as in figure 2 or slots as in figure 3. An YBCO single domain then can be made in only one step from the pellet 20. The cylindrical portions 34 are then sliced in order to obtain separated YBCO single domain plates. Such a pellet 20 allows an easy manufacture of several single domain plates of large dimensions in the ab planes from only one single domain.

The present invention has numerous advantages.

First, it allows the manufacture of YBCO single domains with a reduced number of cracks in the ab planes. The electromagnetic properties of the single domains used as superconductors are then improved since the material is more homogeneous. More particularly, the obtained single domain can be used as a current limiter according to the c direction with a bigger length. Moreover, easily reproducible critical currents can be achieved since the number of cracks are reduced, which is desirable for the manufacture of single domains at an industrial scale. Moreover, mechanical properties of such single domains are improved with regard to commonly manufactured single domains with identical dimensions. Indeed, stronger single domains can be achieved since the number of cracks is reduced. Moreover, the locations and the dimensions of the openings of the pellet are selected not to damage the mechanical properties.

Second, the single domain manufactured according to the present invention has a reduced number of pores or voids. Indeed, such pores or voids spread in the single domain during the fusion step because of a dissolved oxygen excess which cannot be evacuated. According to the present invention, the oxygen excess is evacuated through the multiple exchange surfaces provided by the openings extending through the pellet. The reduction of the number of pores or voids improves the homogeneousness of the currents to flow through the single domain and improves the properties of the single domains.

Third, the shape of the pellet can be chosen according to the desired use of the single domain manufactured from the pellet. As previously described, sections provided in figures 2A, 2B and 2C are particularly adapted for a use of the single domain for current limitation according to the c direction and for levitation and the sections provided in figures 3, 4 and 5 are particularly adapted for a use as a current limiter.

Fourth, the openings made in the pellet keep their shape after manufacturing a single domain from the pellet. They can then be used to improve the cooling of the single domain for specific applications.

Fifth, the openings of the pellet can be made directly during the manufacture of the pellet or by machining the manufactured pellet. Machining the pellet is generally easier than machining the single domain. Moreover, defaults caused by machining the pellet disappear when melting the pellet.

The present description was made with the example of YBCO. However, the invention applies to other rare earth oxides such as neodymium (Nd), samarium (Sm), gadolinium (Gd), europium (Eu), praseodymium (Pr), terbium (Tr), dysprosium (Dy), holmium (Ho), erbium (Er), thulium (Tm), ytterbium (Yb) and lutetium (Lu) or the manufacture of single domains with a mixture of several rare earths. Moreover, examples of pellets with circular, square or hexagonal cross-section openings have been described. It is clear that the openings can have any shape. Besides, the pellet can have any outer shape, the outer shape being in particular dependent on the process selected for manufacturing the pellet.

Having thus described at least one illustrative embodiment of the invention, various alterations, modifications and improvements will readily occur to those skilled in the art. Such alterations, modifications and improvements are intended to be within the spirit and scope of the invention. Accordingly, the foregoing description is by way of example only and is not intended to be limiting. The invention is limited only as defined in the following claims and the equivalent thereto.

## Claims

1. A manufacturing method of a single domain of a rare earth based high critical temperature superconducting oxide, to be used as a superconductor, having different electromagnetic properties in a privileged plane (ab) and in a privileged direction (c), **characterized in that** it comprises the following steps:
- manufacturing an intermediate part (20) from grains or precursors of the rare earth based high critical temperature superconducting oxide, said part comprising openings (21, 22, 23, 24, 30), said openings defining in the intermediate part material portions having, in the privileged plane, a thickness smaller than a predetermined thickness;
- manufacturing the single domain of the rare earth based high critical temperature superconducting oxide from the intermediate part; and
- oxygenating the single domain to increase the oxygen rate of the rare earth based high critical temperature superconducting oxide.

2. A method according to claim 1, wherein the predetermined thickness is 4 millimeters.

3. A method according to claim 1, wherein the intermediate part (20) is made by sintering grains of the rare earth based high critical temperature superconducting oxide, the manufacture of the openings (21, 22, 23, 24, 30) being simultaneous to the manufacture of the intermediate part.

4. A method according to claim 1, wherein the intermediate part (20) and the openings (21, 22, 23, 24, 30) are obtained from extrusion of a paste comprising grains or precursors of the rare earth based high critical temperature superconducting oxide.

5. A method according to claim 1, wherein the openings (21, 22, 23, 24, 30) are made by machining the intermediate part (20).

6. A method according to claim 1, wherein the manufacturing step of the rare earth based high critical temperature superconducting oxide includes a texturing step of the intermediate part (20) by germination from a seed (14), an opening-free rare earth based high critical temperature superconducting oxide interface part (28) being located between the seed and the intermediate part so that the recrystallization progresses from the seed successively into the interface part, and into the intermediate part (20).

7. An intermediate part (20) comprising grains and/or precursors of a rare earth based high critical temperature superconducting oxide to be changed into a single domain of the rare earth based high critical temperature superconducting oxide used as a superconductor with different electromagnetic properties in a privileged plane (ab) and in a privileged direction (c), **characterized in that** it comprises openings (21, 22, 23, 24, 30) defining in the intermediate part material portions having, in the privileged plane, a thickness smaller than a predetermined thickness.

8. An intermediate part (20) according to claim 7, wherein the predetermined thickness is 4 millimeters.

9. An intermediate part (20) according to claim 7, wherein the openings (21, 30) are cylindrical openings extending through the intermediate part (20) along a direction intersecting the privileged plane (ab).

10. An intermediate part (20) according to claim 7, wherein the openings (22, 23) are polygonal cross-section openings extending through the intermediate part (20) along a direction intersecting the privileged plane (ab).

11. An intermediate part (20) according to claim 7, wherein the openings (24) are slots extending through the intermediate part (20) parallel to the privileged direction (c).

12. An intermediate part (20) according to claim 7, including parallel and spaced apart plates (34) located on a trunk (32), each plate comprising openings (21, 22, 23, 24, 30).
